# EUROPEAN PATENT APPLICATION

(11) **EP 0 600 624 A1**
(43) Date of publication of application: **08.06.1994**
(21) Application number: 93308992.2
(22) Date of filing: 10.11.1993
(51) Int. Cl.: H03K 5/19

(54) **Duty discrimination circuit**

(30) Priority: 10.11.1992 JP 299626/92
(71) Applicant: KABUSHIKI KAISHA TOSHIBA, Kawasaki-shi, Kanagawa-ken 210 (JP)
(72) Inventor: Kohsaka, Yoshiaki, c/o Int. Pro. Toshiba Co., Tokyo (JP)
(74) Representative: O'Connell, David Christopher

(57) **Abstract**

In a duty discrimination circuit for discriminating duties of input signals by comparing a count value with a threshold value by counting a time period from a reference level changing point occurring every predetermined period in the input signal to a level returning point with a counter by using clocks, the present invention is characterized by that the duty discrimination circuit is provided with period determination means for determining the periods of the input signals by resetting the count value of the counter at the period of the input signal, and comparing actual count values for a plural number of count patterns of the counter established in advance and clock selection means (10) for selecting the frequency of the clock based on a determination result of the period determination means.

## Description

The present invention relates generally to a duty discrimination circuit, and more particularly, to a duty discrimination circuit for discriminating duties of the control signals to be recorded on a magnetic tape of, for example, a video tape recorder (VTR)

Conventionally a VHS system format for a home VTR has been adapted to use a control coding system for recording a VHS system index search signal (VISS signal) and a VHS system address search signal (VASS signal) on the tape by changing a duty factor or duty ratio of control signals to be recorded on a magnetic tape (hereinafter simply referred to as a tape). This system uses two kind of duty ratios, i.e., the 60 (± 5) % duty and the 27.5 (± 2.5) % duty for the control signals to be recorded, and modulates the control signals according to a predetermined format. Accordingly a reproducer side discriminates between the VISS signal and the VASS signal by discriminating the duties of the control signals.

So, as a way of discriminating the duty ratios of the reproduced control signals, what is done is to count the time that the control signal stays in a high level state based on a predetermined clock, and then compare the count value with a threshold value. Provided that the threshold value is a predetermined constant value, the discriminating operation can not cope with a frequency change of the reproduced control signal. Accordingly a way of changing the threshold value in response to the frequency of the reproduced control signal has been employed.

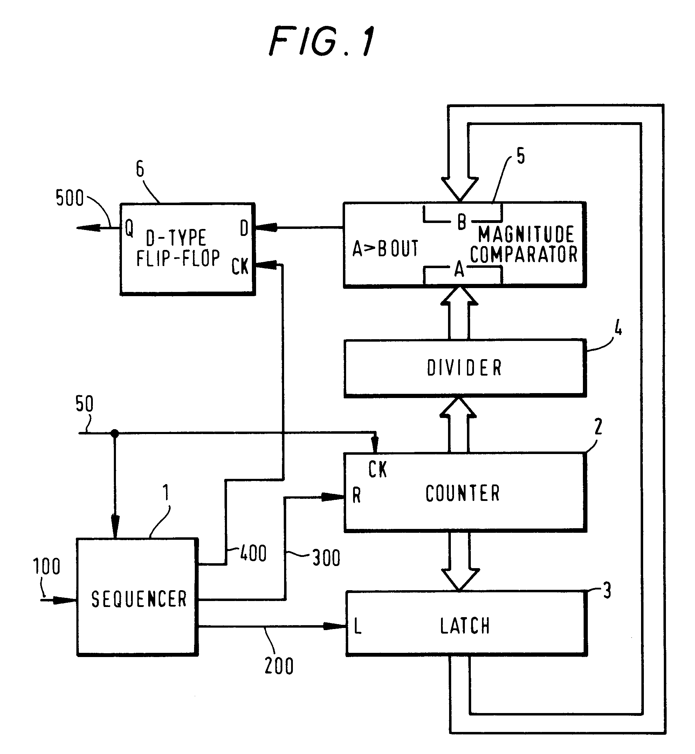

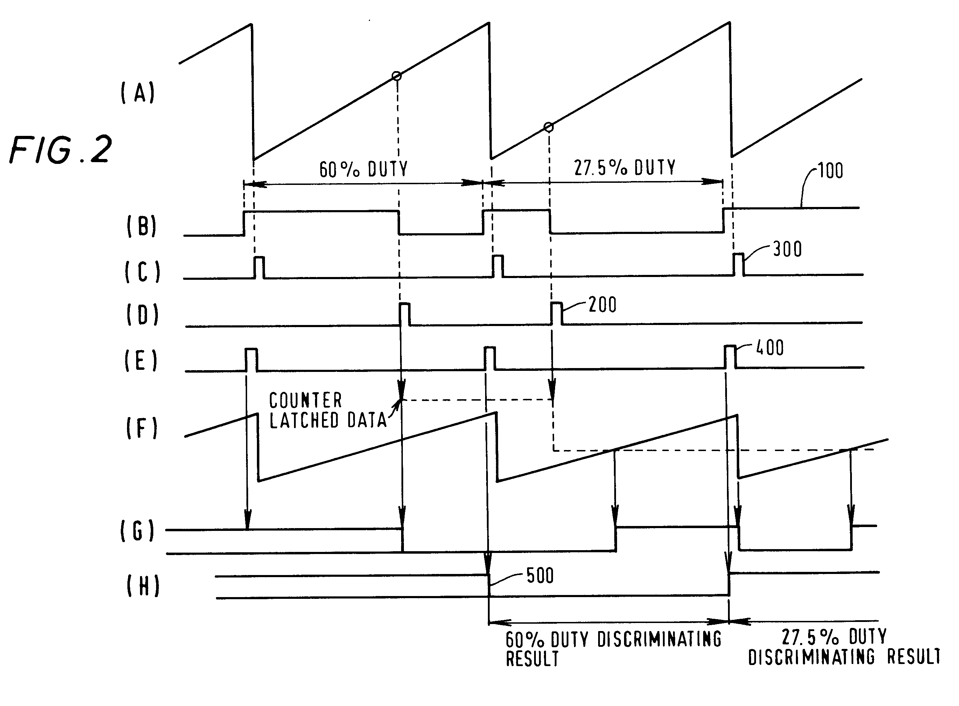

FIGURE 1 is a block diagram showing an example of conventional duty discrimination circuits for discriminating the duties of the control signals. FIGURE 2 is a time chart for explaining the operation of the duty discrimination circuit. 1 denotes a sequencer which generates a counter latch signal 200, a counter reset signal 300 and a sampling pulse 400, based on a reproduced control signal 100 and a reference clock 50. 2 denotes a counter for up-counting the reference clock 50. The counter 2 is reset by the reset signal 300. 3 denotes a latch for latching the count value of the counter 2 at the input timing of the latch signal 200. 4 denotes a divider for dividing the 2(n + 1) bit output of the counter circuit into a half and outputs the divided value as an output A. 5 denotes a magnitude comparator for comparing the magnitudes of the output B of the latch 3 with the output A of the divider 4, then outputs a high level signal into to a D-type flip-flop 6 when A > B. 6 denotes the D-type flip-flop for outputting the comparing result of the magnitude comparator 5 as a duty discriminating signal when the comparing result of the magnitude comparator 5 is applied to its data terminal D, and the sampling pulse 400 is applied to its clock terminal CK.

The sequencer 1 generates the counter latch signal 200, the counter reset signal 300 and the sampling pulse 400 from the reproduced control signal 100, as shown in FIGURE 2(B). After the counter 2 is reset to O at the leading edge of the counter reset signal 300 output from the sequencer 1, as shown in FIGURE 2(c), it starts to count the reference clock 50. The count value thus increases, as shown in FIGURE 2(A). After that, the counter latch signal 200 is output from the sequencer 1, as shown in FIGURE 2(D), the latch 3 latches the count value of the counter 2 at that point, and sends the latched value to the magnitude comparator 5 as an output B (see FIGURE 2(F)).

On the other hand, the divider 4 successively divides the count value of the counter 2 by two and sends the divided value to the magnitude comparator 5. If the output of the divider 4 is smaller than the counter latch signal 200 at the time that the signal 200 is output, the output of the magnitude comparator 5 takes a low level at that time. If the output of the divider 4 becomes larger than the counter latch signal 200 before the counter reset pulse 300 is generated this output takes a high value. While if the output of divider 4 remains smaller than the counter latch signal 200, the output of the magnitude comparator 5 remains in the low level. The comparing result of the magnitude comparator 5 is transferred to the D-type flip-flop 6 at the output timing of the sampling pulse 400. Therefore, when the duty of the control signal is more than 50 %, the Q output of the D-type flip-flop 6 takes the low level (logic value "0"), while when the duty of the control signal is below 50 %, the Q output of the D-type flip-flop 6 takes the high level (logic value "1") and the duty discriminating signal 500 is output, as shown in FIGURE 2(H).

Recent VTRs have a tendency to increase the speeds of fast forwarding/fast rewinding operations for the purpose of improving their operability, and so the frequency range of the reproduced control signal 100 is steadily increasing. Accordingly, to cope with the recent inclination as mentioned above, it is required for the duty discrimination circuit to increase the speed of the reference clock 50 in order to keep the accuracy of the detection in a higher order, and correspondingly to increase the bit scale of the counter 2. For instance, if 2 % has been set as the accuracy of the detection so as to cope with the high speed of 300 times fast forwarding and/or fast rewinding operation, the frequency of the control signal is given by 30 Hz x 300 times = 9 KHz. Accordingly in this case the frequency of the reference clock is given by 9 KHz/0.02 = 450 KHz. To cope with the control signal with the frequency of 30 Hz in the normal operation, the required bit scale of the counter 2 is given by 450 KHz/30 Hz = 15,000, i.e., 14 bit (= 16384). This brings about an increase in the cost of the circuit due to the increase of the circuit scale of the duty discrimination circuit.

As described above, the conventional duty discrimination circuit for discriminating the duty ratios of the reproduced control signals by counting the time that the control signal stays in a high level state based on a predetermined clock, and then compare the count value with a threshold value must use a high speed clock because of the inclination of expanding the frequency range of control signals. Accordingly the conventional circuit had a drawback that it necessitates using a large bit scale counter which causes the circuit scale to be enlarged and also to increase the cost of the circuit.

The present invention seeks to provide a duty discrimination circuit which is able to remove the drawbacks in the prior arts.

The present invention also seeks to provide an inexpensive duty discrimination circuit which is able to avoid an increase of the circuit scale without increasing the bit scale of the counter for counting clocks.

A duty discrimination circuit according to one aspect of the present invention discriminate duties of input signals by comparing a count value with a threshold value by counting a time period from a reference level changing point occurring every predetermined period in the input signal to a level returning point with a counter by using clocks, is provided with period determination means for determining the periods of the input signals by resetting the count value of the counter at the period of the input signal, and comparing actual count values for a plural number of count patterns of the counter established in advance and clock selection means for selecting the frequency of the clock based on a determination result of the period determination means.

In the duty discrimination circuit according to the present invention, the period determination means determines the period of the input signal. The clock selection means selects the frequency of the clocks by the determination result of the period determination means.

For a better understanding of the present invention and many of the attendant advantages thereof, reference will now be made by way of example to the accompanying drawings, wherein:
FIGURE 1 is a block diagram showing a conventional duty discrimination circuit;
FIGURE 2 is a time chart illustrating the operation of the conventional duty discrimination circuit, as shown in FIGURE 1;
FIGURE 3 is a block diagram showing one embodiment of the duty discrimination circuit according to the present invention;
FIGURE 4 is a logic table illustrating the operation of the duty discrimination circuit shown in FIGURE 3; and
FIGURE 5 is a diagram showing the relation of the changing points of the reference clocks with a number of fast operation speeds corresponding to clock changing points in the duty discrimination circuit, as shown in FIGURE 3.

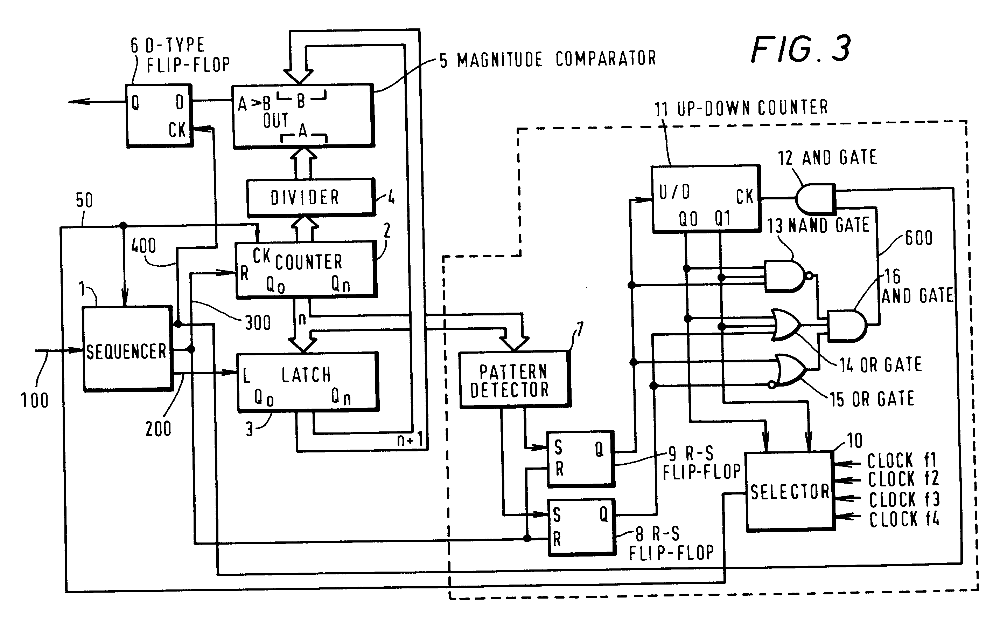

The present invention will be described in detail with reference to the FIGURES 3, 4 and 5. Throughout the drawings, reference numerals or letters used in FIGURES 1 and 2 will be used to designate like or equivalent elements for simplicity of explanation.

Referring now to FIGURE 3, a first embodiment of the duty discrimination circuit according to the present invention will be described in detail. FIGURE 3 is a block diagram showing this embodiment of the duty factor detecting circuit. 1 denotes a sequencer for generating a counter latch signal 200, a counter reset signal 300 and a sampling pulse 400, based on a reproduced control signal 100 and a reference clock 50. 2 denotes a counter up counting the reference clock 50. The counter 2 is reset by the reset signal 300. 3 denotes a latch for latching the count value of the counter 2 at the input timing of the latch signal 200. 4 denotes a divider for dividing the 2(n + 1) bit output of the counter into a half and outputs the divided value as an output A. 5 denotes a magnitude comparator for comparing the magnitudes of the output B of the latch 3 with the output A of the divider 4, then outputs a high level signal into to a D-type flip-flop 6 when A > B. 6 denotes the D-type flip-flop for outputting the comparing result of the magnitude comparator 5 as a duty discriminating signal when the comparing result of the magnitude comparator 5 is applied to its data terminal D, and the sampling pulse 400 is applied to its clock terminal CK. 7 denotes a pattern detection circuit for detecting the point of 12.5 % of the full count value of the counter 2 as a pattern 0 and also the point of 50 % of the full count value of the counter 2 as a pattern 1. 8, 9 denote R-S flip-flops which are set by the detected pattern obtained by the pattern detector circuit 7 and reset by the counter reset signal 300. 10 denotes a selector for selecting one of clocks f1 - f4, whose frequencies are different from each other, according to output signals of an up-down counter 11 as a reference clock 50. The selector 10 selects the highest frequency clock f1 when both the outputs of the up-down counter 11 are 0, while the selector 10 selects the lowest frequency clock f4 when both the outputs of the up-down counter 11 are 1. But f1 > f2 > f3 > f4. 11 denotes the 2 bit up-down counter counting up and down the sampling pulse 400 by the output signal of the R-S flip-flop 9. 12 denotes an AND gate which controls whether or not to supply the sampling signal 400 to the up-down counter 10 according to a clock gate signal 600. 13 denotes a NAND gate. 14, 15 denote OR gates. 16 denotes an AND gate. These gates 13 - 16 generate the clock gate signal 600 based on the output signals Q0, Q1 of the up-down counter 10 and the output signal of the R-S flip-flops 8, 9.

Now the operation of the embodiment as described above will be explained.

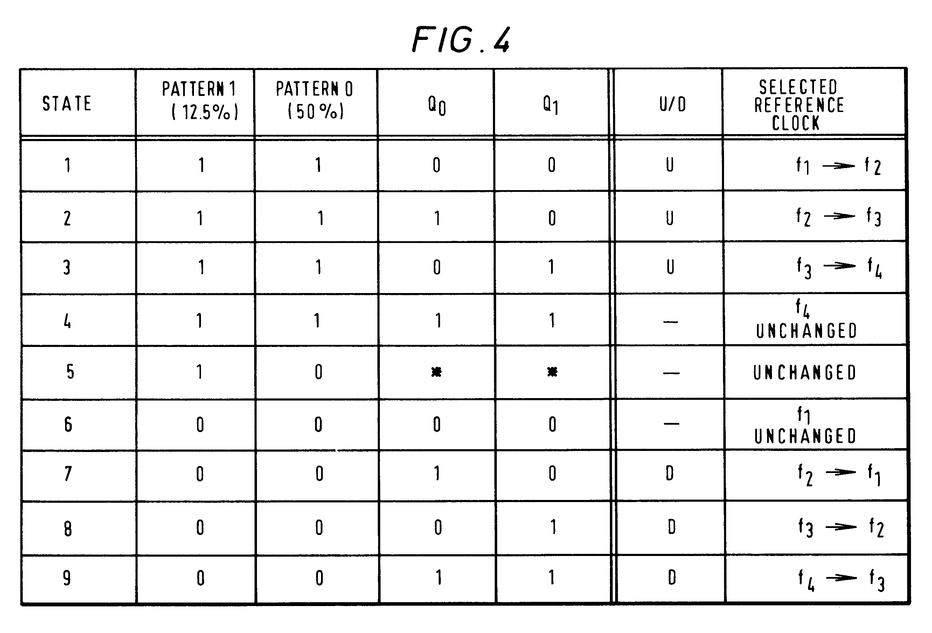

The operations of the counter 2, the latch 3, the divider 4 and the magnitude comparator 5 perform the operations in the same manner as described above in reference Figures 1 and 2. However, in this example, the pattern detection circuit 7 detects the pattern 0 or pattern 1 according to the count value of the counter 2, and then outputs the detected result to the set input terminals S of the R-S flip-flops 8, 9. As a result the R-S flip-flop 8 will be set to "1" when the period of reproduced control signal 100 is more than 12.5 % of the counter period of the counter 2. Similarly, the R-S flip-flop 9 will be set "1" when the period of the reproduced control signal 100 is more than 50 % of the counter 2, these states are listed in the second and the third columns in the table as shown in FIGURE 4. Here, the up-down counter 11 with a 2 bit scale operates its up-count operation at the states 1 - 3 as listed in the first column in the table in FIGURE 4. On the contrary, the up-down counter 11 operates its down-count at the states 7 - 9 as listed on the column. Further at the states 4 - 6, the clock gate signal 600, as shown in FIGURE 3, will be the low level so that the sampling pulse 400 will not be supplied to the up-down counter 11, and thus the clocks will not be supplied to the up-down counter 11.

Now an operation of generating the clock gate signal 600 will be explained. When both the outputs of the NAND gate 13 and the OR gate 14 are "1"; the output of the OR gate 15 will be "1" either when pattern 0 is "0" or pattern 1 is "1", and this will be the clock gate signal 600 through the AND gate 16. When this clock gate signal 600 is "1", the AND gate 12 will open and the sampling pulse 400 will be supplied to the up-down counter 11 as clocks. But when both of the outputs QO, Q1 of the up-down counter 11 are "1" and pattern 1 is "1", the output of the AND gate 12 will be "0", and the AND gate 12 will be closed by closing the AND gate 16 to inhibit the pass of the clock gate signal 600. So, the sampling pulse 400 is not supplied to the up-down counter 11 any more, thus a further counting operation of the up-down counter 11 is inhibited. Therefore, though the lowest frequency clock f4 is selected yet, the further operation of the up-down counter 11 can be inhibited. In the same way, the OR gate 14 inhibits the further operation of the up-down counter 11 though both the outputs Q0, Q1 of the up-down counter 11 are "0" and the highest frequency f1 is selected.

Here, the logic table of the duty discrimination circuit, as shown by FIGURE 4, lists the discriminating states of the pattern detection circuit 7, i.e., the states of the outputs Q0, Q1 of the up-down counter 11 corresponding to the states 1 - 9 and the varieties of the clocks selected by the selector 10 at that time. For instance, the pattern detection circuit 7 at the state 1 detects the "1" as the pattern 0, as well as the state "1" as the pattern 1. Accordingly the up-down counter 11 up-counts the sampling pulse signal 400, so as to change the outputs Q0, Q1, from "0", "0" to "1", "0". When the outputs Q0, Q1 of the up-down counter 11 are "0", "0", the clock f1 has been selected as the reference clock 50 by the selector 10. Thus, the clock f2 is selected as the reference clock 50 to be supplied to the sequencer 1 and the counter 2 by the state changes of the outputs Q0, Q1 to "1", "0". Further in this time, the clock gate signal 600 has been "1", so that the sampling clock 400 has been supplied to the up-down counter 11 through the AND gate 12. And so forth, in this example, the operation of evaluating the period of the reproduced control signal 100 to the presently selected reference clock 50 by the two output signals, i.e., the pattern 1 and the pattern 2 and also the operation of selecting a reference signal with a frequency suitable to the period of the reproduced control signal by the selector 10 are carried out as shown in FIGURE 4.

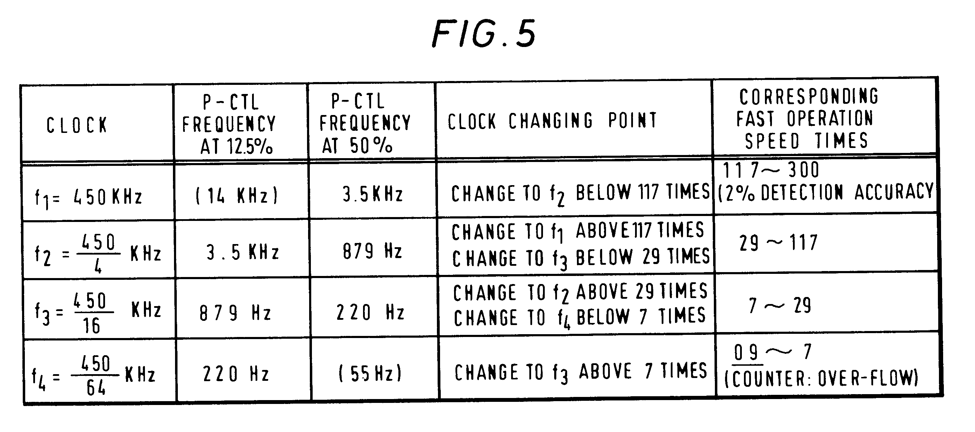

By the way, although the values of the patterns 0 and 1 and the frequencies of the clocks f1 - f4 must be set properly in correspondence with the frequency range of the input signal, they are not limited to specific values. Here, in this example, a case of the high speed of 300 times fast forwarding and/or fast rewinding operation will be described hereinafter. First, the clock f1 is set to 450 KHz, in similar to the case as described above. Also the clocks f2 - f4 are related with each other by the relation of f(n+1) = fn/4, wherein n = 1, 2, 3. The bit scale of the counter 2 to cope with the control signal 100 having the frequency 30 Hz by the clocks is given by f4/30 Hz = 450 KHz/64 x 30 Hz = 234. That is, the bit scale of the counter 2 may be set to 8 bit. FIGURE 5 illustrates a table listing a number of fast operation speeds corresponding to clock changing points (i.e., the points of the 12.5 % and the 50 % as described above) under the above conditions. As will be easily seen from the table in FIGURE 5, the ranges of the fast operation speeds at the clock changing points overlap each other for the respective clocks f1 - f2. This shows that the clock changings operate correctly.

According to the above embodiment, by selectively supplying the reference clock changed among the four steps of clocks f1 - f4, the bit scale needed for the counter 2 can be got through 8 bit to cope with 300 times fast forwarding operation/fast rewinding operation. Also it is able to control the circuit scale small, as well as it is able to cope with the inclination of increasing the speeds of fast forwarding/fast rewinding operations by expanding the frequency range of the reproduced control signal.

As described above, the present invention can provide an extremely preferable duty discrimination circuit. That is, the duty ratio-discrimination circuit according to the present invention can make the circuit inexpensive by suppressing the circuit scale smaller without increasing the bit scale of the counter for counting clocks, even if using the high speed clock for coping with the inclination of expanding the frequency range of control signals.

While there have been illustrated and described what are at present considered to be preferred embodiments of the present invention, it will be understood by those skilled in the art that various changes and modifications may be made, and equivalents may be substituted for elements thereof without departing from the true scope of the present invention. In addition, many modifications may be made to adapt a particular situation or material to the teaching of the present invention without departing from the central scope thereof. Therefore, it is intended that the present invention not be limited to the particular embodiment disclosed as the best mode contemplated for carrying out the present invention, but that the present invention include all embodiments falling within the scope of the appended claims.

The foregoing description and the drawings are regarded by the applicant as including a variety of individually inventive concepts, some of which may lie partially or wholly outside the scope of some or all of the following claims. The fact that the applicant has chosen at the time of filing of the present application to restrict the claimed scope of protection in accordance with the following claims is not to be taken as a disclaimer or alternative inventive concepts that are included in the contents of the application and could be defined by claims differing in scope from the following claims, which different claims may be adopted subsequently during prosecution, for example for the purposes of a divisional application.

## Claims

1. A duty discrimination circuit for discriminating duties of input signals comprising means for counting a time interval of the input signal from a reference level changing point occurring every predetermined period of the input signal to a level returning point by using a clock and means for comparing a count value obtained by the counting means with a prescribed threshold value, characterised in that the circuit further comprises:
means for determining a period of the input signals; and
clock selection means responsive to the period determining means for selecting a specific clock having a frequency suitable to the comparing means.

2. A duty discrimination circuit as claimed in claim 1, wherein the period determining means includes means for resetting the count value obtained by the counting means at the period of the input signal and second comparing means responding to the resetting means for comparing actual count values corresponding to a prescribed number of count patterns preset in the counting means.

3. A duty discrimination circuit as claimed in claim 2, wherein the resetting means includes pattern generator means for selectively generating a set of pattern signals corresponding to the count value of the counting means, up/down counter means for controlling the clock selection means and gate means for selectively activating the up/down counter means by logically responding to the pattern signals generated from the pattern generator means.

4. A circuit for determining a duty factor of an input pulse signal, the circuit comprising:
a clock pulse generator (50);
a counter (2), for counting clock pulses generated during a pulse width of the input pulse signal;
a comparator (5), for comparing the number of counted pulses (B) with a threshold value (A) equivalent to a predetermined fraction of the number of counter pulses generated during one input pulse period, and generating a determination output on the basis of said comparison;
means for determining the input pulse period; and
means (10) for adjusting the clock pulse frequency in response to the period thus determined.

5. A circuit as claimed in claim 4 comprising means for deriving from the number of counted pulses an indication as to whether the input pulse period lies within a given range, appropriate to the clock pulse frequency, and adjusting said frequency if the period lies outside said range.

6. A duty discrimination circuit for discriminating duties of input signals by comparing a count value with a threshold value by counting a time period from a reference level changing point occurring every predetermined period in the input signal to a level returning point with a counter by using clocks, characterised in that the duty discrimination circuit is provided with:
period determination means for determining the periods of the input signals by resetting the count value of the counter at the period of the input signal, and comparing actual count values for a plural number of count patterns of the counter established in advance; and
clock selection means for selecting the frequency of the clock based on a determination result of the period determination means.
